# EUROPÄISCHE PATENTSCHRIFT

(11) **EP 1 604 557 B1**
(45) Veröffentlichungstag und Bekanntmachung des Hinweises auf die Patenterteilung: **03.01.2007**
(21) Anmeldenummer: 03785539.2
(22) Anmeldetag: 28.11.2003
(51) Int. Cl.: H05K 13/08

(54) **VERFAHREN ZUR POSITIONSBESTIMMUNG EINER SAUGPIPETTE**
METHOD FOR DETERMINING THE POSITION OF A VACUUM PIPETTE
PROCEDE POUR DETERMINER LA POSITION D'UNE PIPETTE D'ASPIRATION

(30) Priorität: 19.03.2003 DE 10312251
(43) Veröffentlichungstag der Anmeldung: 14.12.2005
(73) Patentinhaber: SIEMENS AKTIENGESELLSCHAFT, 80333 München (DE)
(72) Erfinder: BURGER, Stefan, 81379 München (DE)
(86) Internationale Anmeldenummer: PCT/DE2003/003937
(87) Internationale Veröffentlichungsnummer: WO 2004/084605

(56) Entgegenhaltungen:
- EP-A- 1 187 524
- PATENT ABSTRACTS OF JAPAN vol. 1998, no. 01, 30. Januar 1998 (1998-01-30) & JP 09 246794 A (MATSUSHITA ELECTRIC IND CO LTD), 19. September 1997 (1997-09-19)

## Beschreibung

Die Erfindung betrifft ein Verfahren zur Positionsbestimmung einer als Haltevorrichtung für Bauelemente dienenden Saugpipette.

Aufgrund der zunehmenden Miniaturisierung von elektronischen Bauelementen müssen moderne Bestückautomaten neben einer hohen Bestückleistung auch eine große Bestückgenauigkeit aufweisen, damit die zu bestückenden Bauelemente möglichst genau an einer vorgegebenen Position auf einer Leiterplatte bzw. auf einem Substrat aufgesetzt werden und somit eine schlechte oder eine fehlende Kontaktierung zwischen Bauelement und Leiterplatte verhindert wird. Eine den modernen Anforderungen genügende Bestückgenauigkeit läßt sich allerdings nicht durch die mechanische Präzision einer in einem Bestückautomaten vorgesehene Positioniervorrichtung für einen Bestückkopf allein erreichen.

Aus diesem Grund werden mechanische Abweichungen, welche beispielsweise durch Fertigungsschwankungen der Positioniervorrichtung oder durch sonstige Verspannungen von einzelnen oder mehreren Komponenten der Positioniervorrichtung verursacht werden, durch eine entsprechende Vorsteuerung in der den Bestückprozess steuernden Software kompensiert. Eine zuverlässige Kompensation dieser mechanischen Abweichungen erfordert vor dem eigentlichen Bestückvorgang eine präzise Vermessung der Positioniervorrichtung.

Die Vermessung einer Positioniervorrichtung erfolgt gemäß dem Stand der Technik beispielsweise dadurch, dass eine mit optischen Markierungen versehene Referenzplatte von einer an dem Bestückkopf oder an der Positioniervorrichtung angebrachten Kamera vermessen wird. Da die Markierungen der Referenzplatte hinsichtlich ihrer Position mit hoher Genauigkeit bekannt sind, kann aus den für die Erfassung der jeweiligen Markierungen erforderlichen Verfahrwege der Positioniervorrichtung eine Verzerrung der Positioniervorrichtung vermessen werden. Die optische Vermessung einer Referenzplatte hat jedoch den Nachteil, dass die Positioniervorrichtung lediglich innerhalb einer Ebene parallel zu der Referenzplatte vermessen wird und Verzerrungen nicht erfasst werden, welche beispielsweise bei einer Bewegung senkrecht zu der Referenzplatte auftreten: Da aber für die Genauigkeit einer Bestückvorrichtung die Präzision der Positioniervorrichtung in der Abhol- bzw. in der Bestückebene der Bauelemente maßgeblich ist, führt die optische Vermessung einer Referenzplatte durch eine Kamera, welche stets mit einem gewissen Parallelversatz zu der Bestückebene bewegt wird, zu einer Ungenauigkeit bei der Vermessung der Positioniervorrichtung.

Aus der EP 968 637 B1 ist ein Verfahren zum Vermessen der Genauigkeit einer in einem Bestückautomatten verwendeten Positioniervorrichtung bekannt, bei dem im Rahmen einer Testbestückung spezielle zum Zwecke der Kalibrierung verwendete Referenz-Bauelemente auf einer Testplatte ausgesetzt werden und die mit diesen Bauelementen bestückte Testplatte, welche eine Reihe von Referenzmarkierungen aufweist, optisch vermessen wird. Anhand der Abweichungen der Ist-Positionen der bestückten Referenz-Bauelemente von den Soll-Positionen kann die Positioniervorrichtung vermessen und Korrekturparameter bestimmt werden, welche bei einer nachfolgenden Bestückung von reellen Bauelementen auf einer Leiterplatte zur Erhöhung der Bestückgenauigkeit verwendet werden. Die genannte Testbestückung hat den Nachteil, dass an dem Vermessungsvorgang unterschiedliche Komponenten eines Bestückautomaten beteiligt sind, deren Ungenauigkeiten sich überlagern. Ein weiterer Nachteil der Testbestückung einer Testplatte besteht darin, dass der gesamte Zeitaufwand für eine Kalibrierung sehr hoch ist.

Der Erfindung liegt die Aufgabe zugrunde, ein schnell und einfach durchführbares Verfahren zur Positionsbestimmung einer als Haltevorrichtung für Bauelemente dienenden Saugpipette zu schaffen, bei dem die Vermessung der Position der Saugpipette in der Bestückebene bzw. in der Abholebene für Bauelemente erfolgt.

Diese Aufgabe wird gelöst durch ein Verfahren zur Positionsbestimmung einer als Haltevorrichtung für Bauelemente dienenden Saugpipette mit den Merkmalen des unabhängigen Anspruchs 1.

Gemäß der Erfindung wird die Saugpipette zunächst mit einem Luftdruck beaufschlagt, welcher im Vergleich zu dem Umgebungsluftdruck einen Druckunterschied aufweist. Auf diese Weise entsteht eine Luftströmung durch den Saugkanal der Saugpipette, wobei die Strömungsrichtung von dem Vorzeichen des Druckunterschiedes abhängt. Die Saugpipette wird nun parallel zu der Oberseite eines Kalibrierelements verfahren, welche Oberseite zumindest eine Unterbrechung aufweist. Da die Oberseite des Kalibrierelements einen gewissen Strömungswiderstand bewirkt, ändert sich der Luftdurchfluss durch die Saugpipette, wenn sich die Saugpipette in unmittelbarer Nähe der Unterbrechung befindet. Für den durch das Kalibrierelement bewirkten Strömungswiderstand ist der Überlapp zwischen der Öffnung der Saugpipette und der Unterbrechung maßgeblich. Durch eine Messung des Luftdurchflusses durch die Saugpipette in Abhängigkeit von der aktuellen Position der Saugpipette kann somit die Position der Saugpipette bestimmt werden. Unter der Voraussetzung, dass die Position der Unterbrechung genau bekannt ist, kann somit die Positioniervorrichtung, mittels welcher die Saugpipette bewegt wird, vermessen werden. Sofern das Kalibrierelement in der Bestückebene bzw. in der Abholebene eines Bestückautomaten angeordnet wird, wird auf diese Weise die Position der Spitze der Saugpipette in unmittelbarer Nähe der Bestück- bzw. Abholebene vermessen. Die Positionsbestimmung der Saugpipette erfolgt somit in einer Ebene, welche für die Genauigkeit beim Bestücken bzw. beim Abholen von Bauelementen maßgeblich ist.

Das Aufsetzen der Spitze der Saugpipette auf das Kalibrierelement gemäß Anspruch 2 hat den Vorteil, dass bei einer Messposition, bei der die Öffnung der Saugpipette keinen Überlapp mit einer Unterbrechung aufweist, der Luftdurchfluss durch die Saugpipette minimal ist. Damit ist der Untergrund der Messkurve, d.h. die Luftmenge, die auf alle Fälle durch die Saugpipette strömt, klein und das resultierende Messsignal bei einer Messposition, bei der die Öffnung der Saugpipette einen maximalen Überlapp mit einer Unterbrechung aufweist, entsprechend deutlich.

Die Beaufschlagung der Saugpipette mit einem Unterdruck gemäß Anspruch 3 hat den Vorteil, dass eine Einrichtung zur Erzeugung von Unterdruck verwendet werden kann, welche in einem herkömmlichen Bestückautomaten ohnehin bereits vorhanden ist.

Das Verfahren nach Anspruch 4 hat den Vorteil, dass die Saugpipette im Prinzip mit einem beliebig großen Überdruck beaufschlagt werden kann, so dass eine starke Luftströmung durch den Saugkanal der Saugpipette strömt und somit die resultierende Genauigkeit der pneumatischen Positionsbestimmung besonders hoch ist.

Gemäß Anspruch 5 wird der Druckunterschied so groß gewählt, dass einerseits die Geschwindigkeit der durch die Saugpipette durchströmenden Luft möglichst groß ist, so dass infolge einer starken Luftströmung eine hohe Genauigkeit der pneumatischen Positionsbestimmung erreicht wird.

Die Verwendung einer Kalibrierplatte gemäß Anspruch 6 hat den Vorteil, dass das Kalibrierelement anstelle einer Leiterplatte in dem Bestückfeld angeordnet werden kann, so dass die Positionsbestimmung der Saugpipette an dem für die Genauigkeit eines Bestückvorgangs maßgeblichen Ort stattfindet. Eine Kalibrierplatte kann auch an der Stelle einer Bauelement-Zuführeinrichtung angeordnet werden, so dass die Position der Saugpipette auch im Abholbereich der Bauelement in der Abholebene bestimmt werden kann. Dies ermöglicht neben der Erhöhung der Bestückgenauigkeit einer Bestückvorrichtung auch die Erhöhung der Abholgenauigkeit, welche insbesondere bei sehr kleinen Bauelementen wichtig ist, damit die zu bestückenden kleinen Bauelemente beim Abholvorgang von der Saugpipette korrekt aufgenommen werden können. Durch eine Positionsbestimmung der Saugpipette unmittelbar in der Bestückebene bzw. in der Abholebene wird somit auf vorteilhafte Weise eine eventuell auftretende Verwindung der Positioniervorrichtung bei einer Bewegung der Saugpipette senkrecht zu der Bestück- bzw. Abholebene erfasst.

Gemäß Anspruch 7 wird eine Kalibrierplatte verwendet, an welcher das Kalibrierelement befestigt ist. Dies hat den Vorteil, dass nicht die ganze Kalibrierplatte, sondern lediglich das Kalibrierelement mit hoher Genauigkeit gefertigt sein muss. Für eine genaue Positionsbestimmung einer Saugpipette ist dann nur erforderlich, dass die Position des Kalibrierelements auf der Kalibrierplatte genau bekannt ist. Die Kalibrierplatte ist bevorzugt aus einem Material hergestellt, welches einen geringen thermischen Ausdehnungskoeffizienten aufweist.

Eine Durchgangsverbindung durch das Kalibrierelement gemäß Anspruch 8 hat den Vorteil, dass die Messung des Luftdurchflusses auch aus Sicht der Saugpipette hinter der Durchgangsverbindung möglich ist. Abhängig von dem Querschnitt der Öffnung der Saugpipette kann als Durchgangsverbindung sowohl ein kreisrundes Loch, ein ovales Loch oder auch ein schlitzförmiger Durchbruch verwendet werden.

Gemäß Anspruch 9 wird als Unterbrechung lediglich eine Vertiefung in dem Kalibrierelement verwendet. Als Vertiefung eignet sich beispielsweise eine grabenartige Aussparung oder eine Nut. Derartige Strukturen können mit einer hohen Genauigkeit im Mikrometerbereich durch eine Mikrostrukturierung beispielsweise in einer Siliziumplatte ausgebildet werden.

Gemäß Anspruch 10 wird der an der Saugpipette abfallende oder der an der Saugpipette angestaute Druck mittels eines Drucksensors gemessen. Dabei ist zu beachten, dass die Vakuum- bzw. Druckerzeugung nicht unmittelbar an der Saugpipette erfolgt, sondern dass zwischen dem druck- bzw. vakuumerzeugenden Element und der Saugpipette ein Zwischenglied angeordnet ist, welches einen Strömungswiderstand aufweist. Bei einer derartigen Reihenschaltung von zumindest zwei Strömungswiderständen - die Saugpipette stellt einen ersten Strömungswiderstand und das Zwischenglied stellt einen zweiten Strömungswiderstand dar - ist der von dem Drucksensor gemessene Druck ein direktes Maß für den Luftdurchfluss durch die Saugpipette. Es wird darauf hingewiesen, dass als Drucksensor ein in herkömmlichen Bestückautomaten ohnehin bereits vorhandener pneumatischer Bauelement-Anwesenheitssensor verwendet werden kann.

Gemäß Anspruch 11 wird der Luftdurchfluss direkt mittels eines Strömungssensors gemessen. Da ein Strömungssensor im allgemeinen einen geringen Strömungswiderstand aufweist kann somit die Stärke der Luftströmung besonders präzise gemessen werden. Dabei kann ein Strömungssensor verwendet werden, welcher in kompakter Bauweise auf einem Messchip angeordnet ist und welcher ein Heizelement, beispielsweise einen Heizdraht sowie ein Thermoelement aufweist. Derartig kompakte Strömungssensoren sind in der Lage, Änderungen von Luftströmungen innerhalb einer kurzen Zeitspanne von bis zu 5 ms zu erfassen. Die Verwendung von Thermoelementen hat den Vorteil, dass der entsprechende Strömungssensor selbst eine Ausgangsspannung generiert, die lediglich von einem Messverstärker verstärkt werden muss, um als Eingangsgröße für eine Auswerteeinheit für die Position der Saugpipette verwendet zu werden.

Mittels einer Drehung der Saugpipette um eine Achse, welche zumindest annähernd parallel zu der Längsachse der Saugpipette verläuft, kann bestimmt werden, ob sich die Pipettenspitze exakt in der Drehachse befindet. Ist dies der Fall, so bleibt die Position der Pipettenspitze bei einer Drehung der Saugpipette unverändert. Ist dies nicht der Fall, weil beispielsweise die Saugpipette infolge einer mechanischen Beanspruchung oder eines Abnutzungseffekts verbogen ist, so beschreibt die Pipettenspitze bei einer Drehung der Saugpipette eine Kreisbewegung. Da während eines Bestückvorgangs ein Drehen der Saugpipette unabdingbar ist, um ein aufgenommenes Bauelement in der richtigen Winkellage auf die Leiterplatte zu setzen, stellt eine derartige Messung des Rundlaufs der Saugpipette gemäß Anspruch 12 eine wichtige Maßnahme dar, um einerseits die Bestückgenauigkeit zu erhöhen und andererseits fehlerhafte Saugpipetten rechtzeitig zu erkennen.

Die Positionsbestimmung der Saugpipetten an einer Mehrzahl von verschiedenen Orten in dem Bestück- bzw. Abholbereich gemäß Anspruch 13 erlaubt eine Messung der Verzerrung der Positioniervorrichtung für sämtliche Positionen der Saugpipette, die sowohl für eine präzise Abholung eines Bauelements als auch für ein präzises Aufsetzen eines Bauelements relevant sind. Dabei können die einzelnen Unterbrechungen gezielt von der Positioniervorrichtung angefahren werden, so dass die Saugpipette lediglich in der Nähe der Unterbrechungen so langsam bewegt wird, dass eine präzise Positionsbestimmung der Saugpipette möglich ist.

Im Zusammenhang mit der Positionsbestimmung der Saugpipette im Abholbereich wird darauf hingewiesen, dass auf diese Weise auch die Position einer Bauelement-Zuführeinrichtung bestimmt werden kann, welche an oder in der Nähe der Abholposition ein Kalibrierelement aufweist. Auf diese Weise kann die genaue örtliche Beziehung zwischen der Bauelement-Zuführeinrichtung und dem Bestückautomaten bestimmt und somit die Abholgenauigkeit verbessert werden.

Das Verfahren nach Anspruch 14 hat den Vorteil, dass die Position der Saugpipette besonders genau ermittelt werden kann. Dies wird beispielsweise dadurch erreicht, dass beim Vorbeifahren der Saugpipette an einer Unterbrechung nicht das Maximum der gemessenen Luftstromstärke ermittelt wird, sondern anhand des Anstiegs und/oder des Abfalls der entsprechenden Messkurve die Positionsbestimmung durchgeführt wird. Dabei ist es auch nicht erforderlich, dass die gesamte Messkurve aufgezeichnet wird, da anhand von wenigen Schwellenwerten, beispielsweise 30% und 70% des maximalen Luftstroms das Maximum der Messkurve bestimmt werden kann, welches in der Mitte zwischen den beiden Positionen liegt, an denen der Schwellenwert erreicht wird. Es wird darauf hingewiesen, dass zur Erhöhung der Messgenauigkeit auch über mehrere Messwerte gemittelt werden kann, welche bei einer Mehrzahl von Positionsbestimmungen an einer oder an mehreren Unterbrechungen aufgezeichnet werden.

Gemäß Anspruch 15 kann die Position der Saugpipette innerhalb eines zweidimensionalen Bestückfeldes bestimmt werden. Dabei wird die Saugpipette bevorzugt entlang einer x-Richtung und der dazu senkrechten verlaufenden y-Richtung der Positioniervorrichtung bewegt.

Die optische Vermessung des Kalibrierelements gemäß Anspruch 16 erfolgt bevorzugt mittels einer in herkömmlichen Bestückautomaten vorhandenen sog. Leiterplatten-Kamera. Durch die zusätzliche optische Vermessung kann das optische Koordinatensystem der Leiterplatten-Kamera mit dem pneumatischen Koordinatensystem der Saugpipette in einen festen räumlichen Bezug gebracht werden. Eine genaue Kenntnis dieses räumlichen Bezuges ist deshalb von Bedeutung, weil bei der automatischen Bestückung einer Leiterplatte die Bauelemente üblicherweise relativ zu einer optisch erfassbaren Markierung an einer bestimmten Position auf der Leiterplatte aufgesetzt werden.

Gemäß Anspruch 17 können zur optischen Vermessung des Kalibrierelements auch Unterbrechungen verwendet werden, die sowohl pneumatisch als auch optisch erfasst werden können. Derartige Unterbrechungen sind beispielsweise in einer SiliziumScheibe ausgebildete Gräben bzw. Nuten, die in Form eines bestimmten Musters angeordnet sind und somit nicht nur pneumatisch sondern auch optisch zuverlässig erfasst werden können.

Gemäß Anspruch 18 wird zusätzlich eine an der Saugpipette seitlich angebrachte Markierung optisch vermessen. Auf diese Weise kann sowohl die Position der Pipettenspitze als auch der Drehwinkel der Pipette gemessen werden. Zur optischen Vermessung kann beispielsweise eine in Bestückautomaten ohnehin vorhandene Bauelemente-Kamera verwendet werden. Im Zusammenhang mit der optischen Vermessung des Kalibrierelements mittels einer Leiterplatten-Kamera können somit die Koordinatensysteme der Bauelemente-Kamera und der Leiterplatten-Kamera durch die pneumatische Positionsbestimmung der Saugpipette miteinander in Bezug gesetzt werden. Für diese Anwendung können spezielle Messpipetten verwendet werden.

Weitere Vorteile und Merkmale der vorliegenden Erfindung ergeben sich aus der folgenden beispielhaften Beschreibung derzeit bevorzugter Ausführungsformen.

In der Zeichnung zeigen in schematischen Darstellunaen
- Figur 1: die Bewegung einer Saugpipette parallel zu der Oberfläche einer Kalibrierplatte,
- Figur 2a, 2b und 2c: die Bewegung einer Saugpipette mit einem kreisförmigen Saugkanal relativ zu verschiedenen in einer Kalibrierplatte ausgebildeten Vertiefungen,
- Figur 3a und 3b: pneumatisch erfassbare Durchgangslöcher und
- Figur 4: eine in der Kalibrierplatte ausgebildete Grabenstruktur, die sowohl optisch als auch pneumatisch erfassbar ist.

An dieser Stelle bleibt anzumerken, dass sich die Bezugszeichen einander entsprechender Komponenten lediglich in ihrer ersten Ziffer unterscheiden.

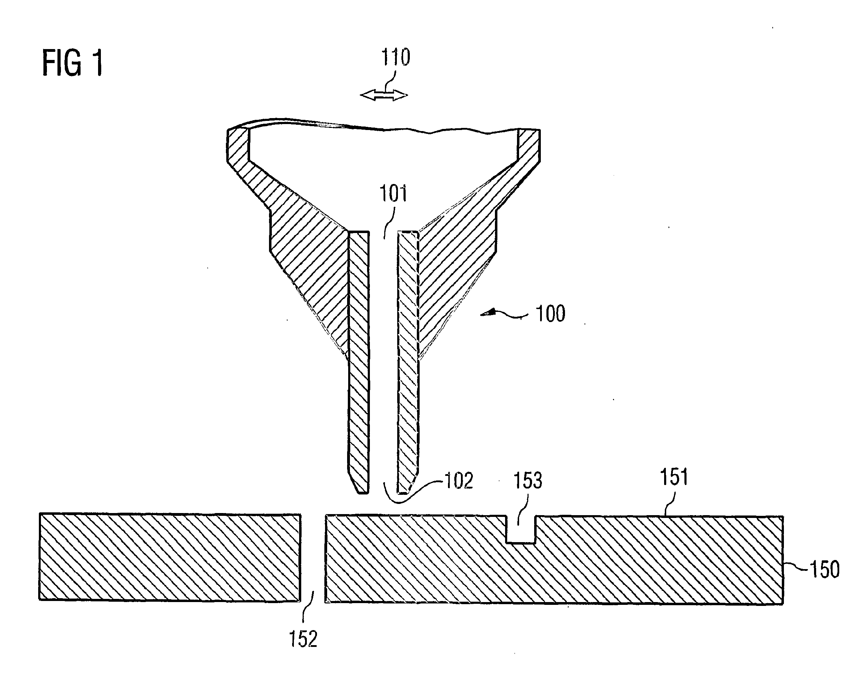

Figur 1 zeigt eine Saugpipette 100, welche einen Saugkanal 101 aufweist, der an der Pipettenspitze in eine Saugöffnung 102 mündet. Die Saugpipette 100 wird entlang der Bewegungsrichtung 110 parallel zu einer Oberseite 151 einer Kalibrierplatte 150 bewegt. Die Saugpipette 100 ist an ihrer der Kalibrierplatte 150 abgewandten Seite mit einer nicht dargestellten Druckerzeugungseinrichtung pneumatisch gekoppelt, welche gegenüber dem umgebenden Luftdruck einen Überdruck erzeugt, so dass Luft durch den Saugkanal 110 in Richtung der Kalibrierplatte 150 strömt. Die Kalibrierplatte 150 stellt für die an der Saugöffnung 102 ausströmende Luft einen Strömungswiderstand dar, so dass die Menge der pro Zeiteinheit aus der Saugöffnung 102 ausströmenden Luft davon abhängt, an welchem Ort relativ zu der Kalibrierplatte 150 sich die exakt parallel zu der Kalibrierplatte 150 bewegte Saugpipette 100 gerade befindet.

Falls sich die Pipette 100 beispielsweise gerade in der in Figur 1 dargestellten Position relativ zu der Kalibrierplatte 150 befindet, wird die aus der Saugöffnung 102 ausströmende Luft durch das Auftreffen auf die Oberseite 151 gebremst. Dadurch erhöht sich der Strömungswiderstand und somit verringert sich die pro Zeiteinheit durch den Saugkanal 101 strömende Luftmenge. Wird die Saugpipette 100 nun entlang der Verschieberichtung 110 nach links bewegt, so überquert die Saugpipette 100 eine Position, in der sich die Saugöffnung 102 unmittelbar oberhalb eines Durchgangslochs 152 befindet. In dieser Stellung strömt ein Großteil der durch die Saugöffnung 102 austretenden Luft durch das Durchgangsloch 152, so dass der resultierende Strömungswiderstand reduziert und die Menge an durch den Saugkanal 101 strömenden Luft erhöht ist. Die Stärke der durch den Saugkanal 101 strömenden Luft ist somit ein Maß für die Position der Saugpipette 100 relativ zu der Kalibrierplatte 150.

Die Menge der durch den Saugkanal 101 strömenden Luft wird auch dann erhöht, wenn die Saugpipette entlang der Bewegungsrichtung 110 nach rechts bewegt wird, so dass sich die Saugöffnung 102 oberhalb einer Vertiefung 153 befindet, welche eine senkrecht zu der Zeichenebene verlaufende Nut ist. Auch in diesem Fall verringert sich der Strömungswiderstand dadurch, dass die aus der Saugöffnung 102 austretende Luft nicht nur oberhalb der Oberseite 151 seitlich wegströmen, sondern auch zumindest teilweise in die Vertiefung 153 eindringen kann und senkrecht zu der Zeichenebene wegströmen kann. Auch in diesem Fall ist somit die Menge der pro Zeiteinheit durch den Saugkanal 101 strömenden Luft ein Maß für den Abstand der Saugöffnung 102 senkrecht zu der Längserstreckung der Nut.

Es wird darauf hingewiesen, dass in analoger Weise die Position der Saugpipette bestimmt werden kann, wenn das der Kalibrierplatte 150 abgewandte Ende der Saugpipette 100 mit einer Vakuumerzeugungseinheit pneumatisch gekoppelt ist, so dass durch den Saugkanal 110 gesaugte Luft durch die Saugöffnung 102 in den Saugkanal 101 eintritt.

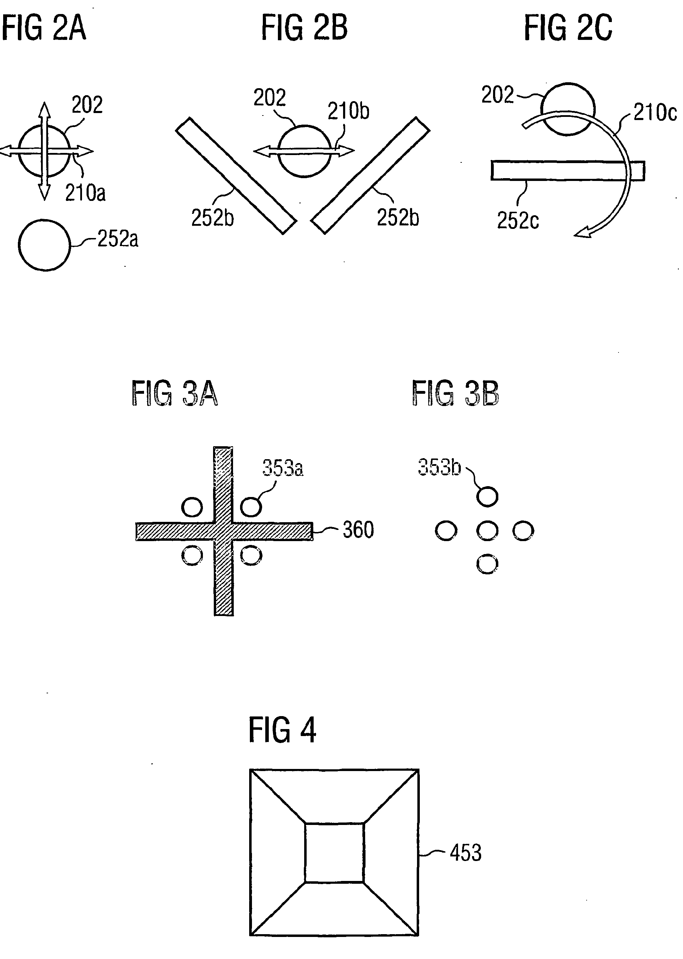

Figur 2 illustriert die Positionsbestimmung einer Saugpipette mit einer kreisrunden Saugöffnung 202 relativ zu Durchgangsverbindungen, die in einer nicht dargestellten Kalibrierplatte ausgebildet sind. Wie aus Figur 2a ersichtlich, wird die Saugpipette relativ zu einem kreisförmigen Durchgangsloch 252a durch eine Bewegung entlang der durch die beiden Doppelpfeile dargestellten Bewegungsrichtungen 210a bewegt. Der Überlapp zwischen der Saugöffnung 202 und dem Durchgangsloch 252a ist ein Maß für den Strömungswiderstand, welcher zwischen Saugpipette und Kalibrierplatte existiert. Je größer dieser Überlapp, desto kleiner ist der Strömungswiderstand und desto größer ist die durch die Saugpipette durchströmende Luftmenge. Zur Positionsbestimmung der Saugpipette relativ zu dem Durchgangsloch 252 kann auch der Anstieg bzw. der Abfall der pro Zeiteinheit durch die Saugpipette durchtretenden Luftmenge verwendet werden, wenn die Saugpipette über das Durchgangsloch 252a hinwegbewegt wird.

Wie aus Figur 2b ersichtlich, wird die Saugpipette entlang der durch den Doppelpfeil dargestellten Bewegungsrichtung 210b relativ zu zwei Durchgangsschlitzen 252b bewegt. Die beiden länglichen Durchgangsschlitze 252b sind in einem Winkel von 90° zueinander angeordnet. Die Bewegung der Saugpipette erfolgt entlang einer Strecke, welche die beiden Durchgangsschlitze 252b in einem Winkel von 45° schneidet. Eine Messung der durch die Saugöffnung 202 durchströmenden Luft ergibt somit eine Messkurve, die zwei Maxima aufweist. Aus dem Verlauf der Messkurve kann die Position der Saugpipette in einem Koordinatensystem, bei dem die x-Achse parallel zu der Bewegungsrichtung 210b und die y-Achse senkrecht zu der Bewegungsrichtung 210b verläuft, genau kalibriert werden. Die Kalibrierung entlang der x-Achse ergibt sich dabei durch das Minimum der Messkurve, welches in der Mitte zwischen den beiden Maxima der Messkurve liegt. Die Kalibrierung entlang der y-Achse ergibt sich aus dem Abstand der beiden Maxima voneinander, da der räumliche Abstand zwischen den beiden Durchgangsschlitzen 252b parallel zur x-Richtung bei der dargestellten Bewegung von der y-Koordinate der Saugpipette abhängt.

Figur 2c illustriert ein Verfahren, bei dem eine speziell gefertigte Messpipette über einen Durchgangsschlitz 252c mittels einer Dreheinrichtung um ihre Achse gedreht wird. Die Messpipette weist eine genau definierte Exzentrizität der Pipettenspitze auf, so dass bei einer Drehung der Messpipette die Bewegung der Saugöffnung 202 eine Kreisbewegung 210c beschreibt. Bei einer Drehung der Messpipette um 360° ergibt sich somit eine Messkurve, welche ebenfalls zwei Maxima aufweist. Auch hier ist der Abstand zwischen beiden Maxima ein Maß für die relative Lage der Pipettenachse senkrecht zu der Längserstreckung des Durchgangsschlitzes 252c. Bei einem Bestückautomaten, bei dem der Bestückkopf lediglich entlang einer Richtung bewegt wird, kann dieses Verfahren beispielsweise dazu verwendet werden, um die genaue Position einer an den Bestückautomaten angedockten Bauelement-Zuführeinrichtung zu bestimmen. Dabei wird davon ausgegangen, dass sich der Durchgangsschlitz 252c an der Bauelement-Zuführeinrichtung seitlich neben einer Bauelement-Abholposition befindet, so dass sich aus der Position der beiden Maxima der resultierenden Messkurve die Andockposition der Bauelement-Zuführeinrichtung senkrecht zu der Längserstreckung des Durchgangsschlitzes 252c ergibt.

Figur 3a zeigt einen Teilbereich einer Kalibrierplatte, in welchem sich pneumatisch erfassbare Durchgangslöcher 353a und eine optisch erfassbare Markierung 360 befinden. Die Durchgangslöcher 353a werden, wie oben anhand von Figur 2a erläutert, pneumatisch erfasst und somit die Position der Saugpipette bestimmt. Die Markierung 360 wird mittels einer Leiterplattenkamera erfasst. Durch einen Vergleich der pneumatisch erfassten Durchgangslöcher 353a und der optisch erfassten Markierung 360 kann ein fester räumlicher Bezug zwischen dem optischen Koordinatensystem der Leiterplatten-Kamera und dem pneumatischen Koordinatensystem der Saugpipette hergestellt werden. Da bei der automatischen Bestückung einer Leiterplatte die Bauelemente üblicherweise relativ zu einer optisch erfassbaren Markierung an einer bestimmten Position auf der Leiterplatte aufgesetzt werden, ermöglicht eine genau Kenntnis dieses räumlichen Bezuges eine hohe Bestückgenauigkeit.

Figur 3b zeigt einen Teilbereich einer Kalibrierplatte, in welchem fünf Durchgangslöcher 353b angeordnet sind, welche sowohl pneumatisch als auch optisch erfasst werden können. Durch die sowohl pneumatische als auch optische Erfassung der Durchgangslöcher 353b kann ebenfalls ein Bezug zwischen dem optischen Koordinatensystem der Leiterplatten-Kamera und dem pneumatischen Koordinatensystem der Saugpipette hergestellt werden.

Figur 4 zeigt gemäß einem weiteren Ausführungsbeispiel der Erfindung eine sowohl pneumatisch als auch optisch erfassbare Struktur 453, die auf einer Kalibrierplatte ausgebildet ist. Die dargestellte Struktur 453 weist eine symmetrische Anordnung verschiedener Nuten bzw. Gräben auf, die beispielsweise in einer Silizium-Kalibrierscheibe mittels sog. Mikrostrukturierung ausgebildet werden können. Bei einem Vorbeibewegen einer Saugpipette an der Grabenstruktur 453 ändert sich, ähnlich wie zuvor anhand von Figur 1 beschrieben, die durch die Saugpipette pro Zeiteinheit strömende Luftmenge.

Zusammenfassend schafft die Erfindung ein Verfahren zur pneumatischen Positionsbestimmung einer als Haltevorrichtung für Bauelemente dienenden Saugpipette 100, bei dem die Saugpipette 100 mit einem Luftdruck beaufschlagt wird, welcher im Vergleich zu dem Umgebungsluftdruck einen Druckunterschied aufweist. Die Saugpipette 100 wird parallel zu der Oberseite 151 eines Kalibrierelements 150 bewegt, welche Oberseite 151 zumindest eine Unterbrechung 152,153 aufweist. Da der Strömungswiderstand für die durch die Saugpipette 100 strömende Luft von dem Überlapp zwischen der Öffnung 102 der Saugpipette 100 und der Unterbrechung 152,153 abhängt, kann anhand der pro Zeiteinheit durch die Saugpipette 100 strömende Luftmenge die aktuelle Position der Saugpipette 100 relativ zu dem Kalibrierelement 150 gemessen werden.

## Patentansprüche

1. Verfahren zur Positionsbestimmung einer als Haltevorrichtung für Bauelemente dienenden Saugpipette, bei dem
• die Saugpipette (100) mit einem Luftdruck beaufschlagt wird, welcher im Vergleich zu dem Umgebungsluftdruck einen Druckunterschied aufweist,
• die Saugpipette (100) parallel zu der Oberseite (151) eines Kalibrierelements (150) bewegt wird, welche Oberseite (151) zumindest eine Unterbrechung (152,153) aufweist, und
• der Luftdurchfluss durch die Saugpipette (100) in Abhängigkeit der Position der Saugpipette (100) gemessen wird.

2. Verfahren nach Anspruch 1, bei dem der Luftdurchfluss an diskreten Messpositionen der Saugpipette (100) gemessen wird, wobei die Spitze der Saugpipette (100) zur Messung des Luftdurchflusses an jeder Messposition kurzzeitig auf das Kalibrierelement (150) aufgesetzt wird.

3. Verfahren nach einem der Ansprüche 1 bis 2, bei dem die Saugpipette (100) mit einem Unterdruck beaufschlagt wird.

4. Verfahren nach einem der Ansprüche 1 bis 2, bei dem die Saugpipette (100) mit einem Überdruck beaufschlagt wird.

5. Verfahren nach einem der Ansprüche 1 bis 4, bei dem der Druckunterschied so groß gewählt wird, dass, wenn sich die Saugpipette (100) in minimalem Abstand von der Unterbrechung (152,153) befindet, die Geschwindigkeit der durch die Saugpipette (100) durchfließenden Luft annähernd Schallgeschwindigkeit erreicht.

6. Verfahren nach einem der Ansprüche 1 bis 5, bei dem als Kalibrierelement eine Kalibrierplatte (150) verwendet wird.

7. Verfahren nach einem der Ansprüche 1 bis 5, bei dem eine Kalibrierplatte (150) verwendet wird, an welcher das Kalibrierelement befestigt ist.

8. Verfahren nach einem der Ansprüche 1 bis 7, bei dem als Unterbrechung (152,153) eine Durchgangsverbindung (152) durch das Kalibrierelement (150) verwendet wird.

9. Verfahren nach einem der Ansprüche 1 bis 7, bei dem als Unterbrechung (152,153) eine Vertiefung (153) verwendet wird.

10. Verfahren nach einem der Ansprüche 1 bis 9, bei dem der Luftdurchfluss mittels eines Drucksensors gemessen wird.

11. Verfahren nach einem der Ansprüche 1 bis 10, bei dem der Luftdurchfluss mittels eines Strömungssensors gemessen wird.

12. Verfahren nach einem der Ansprüche 1 bis 11, bei dem die Saugpipette (100) mittels einer Dreheinrichtung um eine Achse gedreht wird, welche zumindest annähernd parallel zu der Längsachse der Saugpipette (100) verläuft.

13. Verfahren nach einem der Ansprüche 1 bis 12, bei dem die Saugpipette (100) über eine Mehrzahl von verschiedenen Unterbrechungen (152,153) bewegt wird und jeweils der Luftdurchfluss in Abhängigkeit von der aktuellen Position der Saugpipette (100) gemessen wird.

14. Verfahren nach einem der Ansprüche 1 bis 13, bei dem für jede Unterbrechung (152,153) der Luftdurchfluss an einer Mehrzahl von diskreten Positionen der Saugpipette (100) gemessen wird und die Positionsbestimmung mittels einer Interpolation zwischen diesen Messwerten durchgeführt wird.

15. Verfahren nach einem der Ansprüche 1 bis 14, bei dem die Saugpipette (100) entlang von zumindest zwei winklig zueinander verlaufenden Richtungen relativ zu der Unterbrechung (152,153) bewegt wird.

16. Verfahren nach einem der Ansprüche 1 bis 15, bei dem zusätzlich zumindest eine an dem Kalibrierelement (150) befindliche Markierung (360) optisch vermessen wird.

17. Verfahren nach Anspruch 16, bei dem die zumindest eine Unterbrechung (152,153) zusätzlich optisch vermessen wird.

18. Verfahren nach einem der Ansprüche 1 bis 17, bei dem zusätzlich eine an der Saugpipette (100) angebrachte Marke optisch vermessen wird.

## Claims

1. Method for determining the position of a suction pipette used as a holding device for components, wherein
• the suction pipette (100) is subjected to an air pressure, which has a pressure difference compared with the ambient air pressure,
• the suction pipette (100) is moved parallel to the upper face (151) of a calibration element (150), said upper face (151) having at least one break (152, 153) and
• the throughflow of air through the suction pipette (100) is measured as a function of the position of the suction pipette (100) .

2. Method according to claim 1, wherein the throughflow of air is measured at discrete measuring positions of the suction pipette (100), the tip of the suction pipette (100) being positioned temporarily on the calibration element (150) to measure the throughflow of air at each measuring position.

3. Method according to one of claims 1 to 2, wherein the suction pipette (100) is subjected to a low pressure.

4. Method according to one of claims 1 to 2, wherein the suction pipette (100) is subjected to a high pressure.

5. Method according to one of claims 1 to 4, wherein the pressure difference is selected to be so great that, when the suction pipette (100) is at a minimum distance from the break (152, 153), the speed of the air flowing through the suction pipette (100) reaches approximately the speed of sound.

6. Method according to one of claims 1 to 5, wherein a calibration plate (150) is used as the calibration element.

7. Method according to one of claims 1 to 5, wherein a calibration plate (150), to which the calibration element is attached, is used.

8. Method according to one of claims 1 to 7, wherein a through-connection (152) through the calibration element (150) is used as the break (152, 153).

9. Method according to one of claims 1 to 7, wherein a recess (153) is used as the break (152, 153).

10. Method according to one of claims 1 to 9, wherein the throughflow of air is measured using a pressure sensor.

11. Method according to one of claims 1 to 10, wherein the throughflow of air is measured using a flow sensor.

12. Method according to one of claims 1 to 11, wherein the suction pipette (100) is rotated using a rotation facility about an axis, which runs at least approximately parallel to the longitudinal axis of the suction pipette (100).

13. Method according to one of claims 1 to 12, wherein the suction pipette (100) is moved over a number of different breaks (152, 153) and the throughflow of air is measured in each instance as a function of the current position of the suction pipette (100).

14. Method according to one of claims 1 to 13, wherein the throughflow of air is measured at a number of discrete positions of the suction pipette (100) for each break (152, 153) and the position is determined by interpolating these measured values.

15. Method according to one of claims 1 to 14, wherein the suction pipette (100) is moved along at least two directions at angles to each other in relation to the break (152, 153).

16. Method according to one of claims 1 to 15, wherein at least one marking (360) on the calibration element (150) is also measured optically.

17. Method according to claim 16, wherein the at least one break (152, 152) is also measured optically.

18. Method according to one of claims 1 to 17, wherein a mark on the suction pipette (100) is also measured optically.

## Revendications

1. Procédé pour déterminer la position d'une pipette d'aspiration servant de dispositif de maintien pour des composants, dans lequel
• la pipette d'aspiration (100) est alimentée avec une pression d'air qui, en comparaison à la pression d'air ambiant, présente une différence de pression,
• la pipette d'aspiration (100) est déplacée parallèlement au côté supérieur (151) d'un élément de calibrage (150), lequel côté supérieur (151) présente au moins une rupture (152, 153), et
• le flux d'air à travers la pipette d'aspiration (100) est mesuré en fonction de la position de la pipette d'aspiration (100).

2. Procédé selon la revendication 1, dans lequel le flux d'air est mesuré à des positions de mesure discrètes de la pipette d'aspiration (100), la pointe de la pipette d'aspiration (100) étant temporairement posée à chaque position de mesure sur l'élément de calibrage (150) pour la mesure du flux d'air.

3. Procédé selon l'une quelconque des revendications 1 à 2, dans lequel la pipette d'aspiration (100) est alimentée avec une sous-pression.

4. Procédé selon l'une quelconque des revendications 1 à 2, dans lequel la pipette d'aspiration (100) est alimentée avec une surpression.

5. Procédé selon l'une quelconque des revendications 1 à 4, dans lequel la différence de pression est sélectionnée de telle manière élevée que, lorsque la pipette d'aspiration (100) se trouve à écart minimal de la rupture (152, 153), la vitesse de l'air circulant à travers la pipette d'aspiration (100) atteint approximativement la vitesse du son.

6. Procédé selon l'une quelconque des revendications 1 à 5, dans lequel une plaque de calibrage (150) est utilisée comme élément de calibrage.

7. Procédé selon l'une quelconque des revendications 1 à 5, dans lequel une plaque de calibrage (150) est utilisée, sur laquelle est fixé l'élément de calibrage.

8. Procédé selon l'une quelconque des revendications 1 à 7, dans lequel une liaison de passage (152) à travers l'élément de calibrage (150) est utilisée comme rupture (152, 153).

9. Procédé selon l'une quelconque des revendications 1 à 7, dans lequel un approfondissement (153) est utilisé comme rupture (152, 153).

10. Procédé selon l'une quelconque des revendications 1 à 9, dans lequel le flux d'air est mesuré au moyen d'un capteur de pression.

11. Procédé selon l'une quelconque des revendications 1 à 10, dans lequel le flux d'air est mesuré au moyen d'un capteur de flux.

12. Procédé selon l'une quelconque des revendications 1 à 11, dans lequel la pipette d'aspiration (100) est pivotée autour d'un axe au moyen d'un dispositif de rotation, cet axe s'étendant au moins approximativement parallèlement à l'axe longitudinal de la pipette d'aspiration (100).

13. Procédé selon l'une quelconque des revendications 1 à 12, dans lequel la pipette d'aspiration (100) est déplacée par l'intermédiaire d'une pluralité de différentes ruptures (152, 153) et le flux d'air est respectivement mesuré en fonction de la position actuelle de la pipette d'aspiration (100).

14. Procédé selon l'une quelconque des revendications 1 à 13, dans lequel pour chaque rupture (152, 153) le flux d'air est mesuré sur une pluralité de positions discrètes de la pipette d'aspiration (100) et la détermination de la position est réalisée au moyen d'une interpolation entre ces valeurs de mesure.

15. Procédé selon l'une quelconque des revendications 1 à 14, dans lequel la pipette d'aspiration (100) est déplacée par rapport à la rupture (152, 153) le long d'au moins deux directions s'étendant angulairement l'une par rapport à l'autre.

16. Procédé selon l'une quelconque des revendications 1 à 15, dans lequel au moins un repère (360) se trouvant sur l'élément de calibrage (150) est mesuré en outre optiquement.

17. Procédé selon la revendication 16, dans lequel l'au moins une rupture (152, 153) est mesurée en outre optiquement.

18. Procédé selon l'une quelconque des revendications 1 à 17, dans lequel une marque appliquée sur la pipette d'aspiration (100) est mesurée en outre optiquement.
